# EUROPEAN PATENT APPLICATION

(11) **EP 0 786 812 A2**
(43) Date of publication of application: **30.07.1997**
(21) Application number: 97100692.9
(22) Date of filing: 17.01.1997
(51) Int. Cl.: H01L 27/108, H01L 21/8242

(54) **Semiconductor device having inter-level insulating layer allowing hydrogen to penetrate thereinto and process of fabrication thereof**

(30) Priority: 17.01.1996 JP 5494/96
(71) Applicant: NEC CORPORATION, Tokyo (JP)
(72) Inventor: Watanabe, Hirohito, Minato-ku, Tokyo (JP)
(74) Representative: Betten & Resch

(57) **Abstract**

A cylindrical storage electrode (43h) of a dynamic random access memory cell is fabricated through the steps of forming a column portion (43g) of polysilicon on an upper layer (44b) of an inter-level insulating structure (44) formed of silicon oxide, covering the column portion with a first conductive layer (43b) of doped polysilicon, covering the first conductive layer with an insulating layer (43c) of silicon oxide, anisotropically etching the insulting layer for forming a cylindrical side wall spacer (43d), covering the first conductive layer and the cylindrical side wall spacer with a second conductive layer (43j) of doped polysilicon, anisotropically etching the first and second conductive layer until the cylindrical side wall spacer is exposed and removing the cylindrical side wall spacer (43d), and the inter-level insulating layer allows hydrogen to reach an access transistor (42) during a hydrogen treatment, because no silicon nitride layer is left in the structure.

## Description

### FIELD OF THE INVENTION

This invention relates to a semiconductor device and, more particularly, to a structure of the semiconductor device and a process of fabrication thereof.

### DESCRIPTION OF THE RELATED ART

A semiconductor dynamic random access memory device has increased memory cells, and the increase of integration density is achieved by reducing an occupation area assigned to each memory cell. A three-dimensional cell structure drastically reduces the occupation area. A typical example of the three-dimensional cell structure is known as a stacked capacitor cell, which has an access transistor fabricated on the major surface of a semiconductor substrate and a stacked capacitor provided over the major surface. Although various stacked capacitors have been proposed, a stacked capacitor with a cylindrical storage electrode is attractive, because not only the outer surface but also inner surface are available for accumulating electric charge. The stacked capacitor with a cylindrical storage electrode is hereinbelow referred to "cylindrical stacked capacitor".

The cylindrical stacked capacitor has been modified so as to further increase the charge accumulating surface. One of the modifications is disclosed in Japanese Patent Publication of Unexamined Application (JPA) No. 6-37271, and Japanese Patent Publication of Unexamined Application (JPA) No. 5-218333 discloses another modification.

Figures 1A to 1C illustrate essential steps of the process disclosed in Japanese Patent Publication of Unexamined Application No. 6-37271. The process starts with preparation of a p-type silicon substrate 1, and a field oxide layer 1a is selectively grown on the major surface of the p-type silicon substrate 1. The field oxide layer 1a defines a plurality of active areas, and a pair of memory cells is assigned to one of the active areas.

Subsequently, an access transistor 2 is fabricated on the active area in the major surface of the silicon substrate 1 as follows. First, a thin gate oxide layer 2a is thermally grown in the active area, and a conductive layer of polysilicon or refractory metal silicide is laminated on the thin gate oxide layer 2a. A photo-resist etching mask (not shown) is provided on the conductive layer through a lithographic process, and the conductive layer is patterned into word lines 2b. One of the word lines 2b serves as a gate electrode of the access transistor 2. Using the gate electrode 2b as an ion-implantation mask, arsenic or phosphorous is ion implanted into the active area, and forms a source region 2c and a drain region 2d. The gate oxide layer 2a, the gate electrode 2b, the source region 2c and the drain region 2d form in combination the access transistor 2.

Subsequently, silicon dioxide is deposited over the entire surface of the resultant structure for forming a silicon dioxide layer 3a, and, thereafter, silicon nitride is deposited over the silicon dioxide layer 3a. The silicon dioxide layer 3a and the silicon nitride layer 3b form an inter-level insulating structure 3.

Subsequently, a contact hole 3c is formed in the inter-level insulating structure 3. A photo-resist etching mask (not shown) is provided on the silicon nitride layer 3b, and the silicon nitride layer 3b and the silicon dioxide layer 3a are partially etched away so as to expose the source region 2c to the contact hole 3c.

Subsequently, polysilicon is deposited over the entire surface of the resultant structure. The polysilicon fills the contact hole 3c, and swells into a polysilicon layer. Silicon dioxide is deposited over the polysilicon layer, and a silicon dioxide layer is laminated on the polysilicon layer.

A photo-resist etching mask (not shown) is provided on the silicon dioxide layer, and the silicon dioxide layer and the polysilicon layer are partially etched away so as to form a main portion 4a of a cylindrical storage electrode 4b covered with a silicon dioxide layer 4c (see figure 1A).

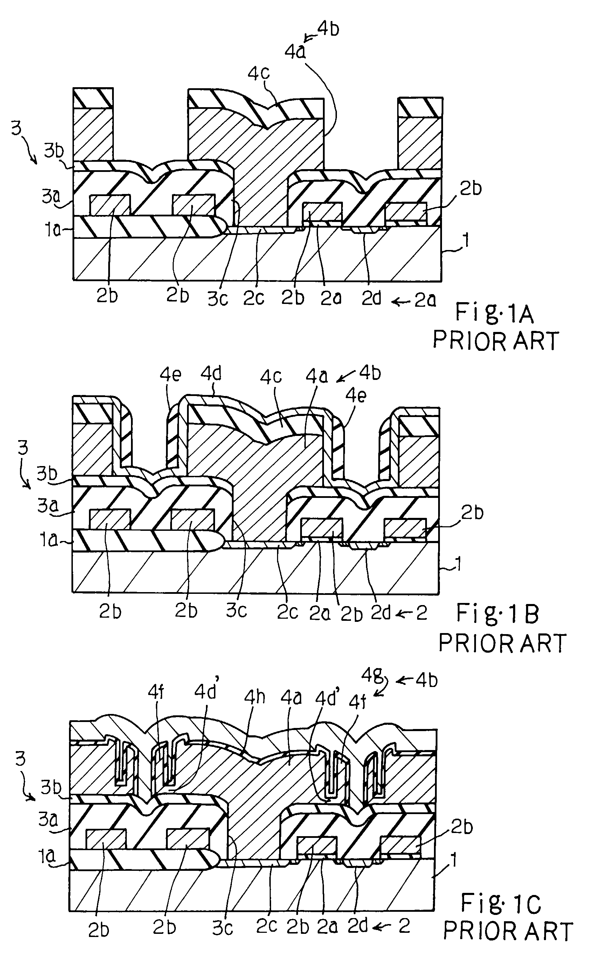

Subsequently, polysilicon is deposited over the entire surface of the structure so as to form a polysilicon layer 4d over the entire surface of the structure. Silicon dioxide is deposited over the polysilicon layer 4d, and a silicon dioxide layer is laminated on the polysilicon layer 4d. The silicon dioxide layer is anisotropically etched, and side walls 4e/4f are left on the vertical surfaces of the polysilicon layer 4d as shown in figure 1B.

Subsequently, polysilicon is deposited over the entire surface of the structure, and the resultant structure shown in figure 1B is covered with a polysilicon layer. Using the silicon nitride layer 3b and the silicon dioxide layer 4c as an etching stopper, the polysilicon layer and the exposed portion of the polysilicon layer 4d are subjected to a reactive etching, and the polysilicon layer is patterned into a cylindrical portion 4f. The cylindrical portion 4f is connected through a remaining portion 4d' of the polysilicon layer 4d to the main portion 4a. Subsequently, the silicon dioxide layer 4c and the side wall 4e are etched away by using hydrofluoric acid. The main portion 4a, the remaining portion 4d' and the cylindrical portion 4f form in combination a storage electrode 4g, and phosphorous is introduced into the storage electrode 4g.

Silicon dioxide and, thereafter, silicon nitride are successively deposited over the entire surface of the structure, and the storage electrode 4g is covered with a dielectric layer 4h. Finally, phosphorous-doped polysilicon is deposited over the dielectric layer 4h, and the dielectric layer 4h is covered with a plate electrode 4i as shown in figure 1C.

The prior art process disclosed in Japanese patent Publication of Unexamined Application No. 5-218333 discloses another prior art process, and a cylindrical storage electrode is formed from a single polysilicon layer. The prior art process sequence proceeds as follows.

First, a field oxide 1a is selectively grown on the major surface of a silicon substrate 1, and an access transistor 11 is fabricated on an active area as similar to the access transistor 2. The access transistor 11 includes a gate oxide layer 11a, a gate electrode 11b, a source region 11c and a drain region 11d.

Subsequently, a lower inter-level insulating structure 12a is formed over the access transistor 11, and is overlain by a smoothening layer 12b. The smoothening layer 12b provides a flat surface. Silicon nitride is deposited entire surface of the smoothening layer 12b, and forms a silicon nitride layer 12c. The silicon nitride layer 12c serves as an etching stopper. Silicon oxide is deposited over the silicon nitride layer 12c, and the silicon nitride layer 12c is overlain by a silicon oxide layer 12d.

A photo-resist etching mask (not shown) is provided on the silicon oxide layer 12d, and the silicon oxide layer 12d, the silicon nitride layer 12c, the smoothening layer 12b and the lower inter-level insulating structure 12a are partially etched away so as to form a contact hole. The source region 11c is exposed to the contact hole. Silicon nitride and silicon oxide are successively deposited to the entire surface of the resultant structure, and are anisotropically etched away so as to form a spacer 12e on the inner surface defining the contact hole. Thus, the inter-level insulating structure 12a/12b and the access transistor 11 are wrapped in the silicon nitride layer 12c and the silicon nitride layer of the spacer 12e.

Subsequently, polysilicon is deposited over the entire surface of the resultant structure. The polysilicon fills the contact hole, and swells into a polysilicon layer 13a. Oxide is deposited over the entire surface of the polysilicon layer 13a, and the polysilicon layer 13a is overlain by an oxide layer. Thereafter, polysilicon is deposited over the oxide layer, and the oxide layer is overlain by a polysilicon layer. An appropriate photo-resist etching mask is provided on the polysilicon layer, and the polysilicon layer and the oxide layer are partially etched away so as to leave a lamination of an oxide strip 13b and a polysilicon strip 13c. The lamination of the oxide strip 13b and the polysilicon strip 13c is located over the source region 11c.

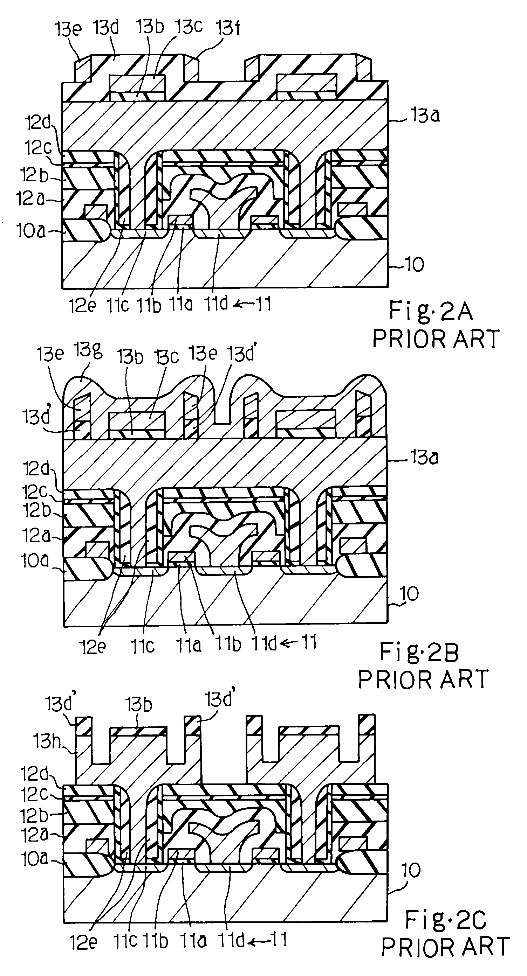

The resultant structure is topographically covered with a coating layer 13d, and the coating layer 13d is overlain by a polysilicon layer. The polysilicon layer is anisotropically etched, and spacers 13e/13f are left on the vertical walls of the coating layer 13d as shown in figure 2A.

Using the spacers 13e/13f as an etching mask, the coating layer 13d is patterned, and protective strips 13d' are left beneath the polysilicon spacers 13e/13f. Polysilicon is deposited over the entire surface of the resultant structure, and the polysilicon layer 13g is as thick as a half of the polysilicon strips 13e/13f. The resultant structure of this stage is illustrated in figure 2B.

The polysilicon layer 13g, the polysilicon spacers 13e/13f and the polysilicon layer 13a are uniformly etched. The oxide strip 13b and the protective strips 13d' prevent the polysilicon therebeneath from the etchant, and the polysilicon layer 13a is formed into a cylindrical storage electrode 13h as shown in figure 2C.

Subsequently, the oxide strip 13b and the protective strips 13d' are removed from the structure shown in figure 2C, and dielectric layer (not shown) is topographically formed over the cylindrical storage electrode 13h. Finally, doped polysilicon is deposited over the dielectric layer, and form a plate electrode (not shown).

The prior art processes patterns the cylindrical storage electrodes which surely increases the accumulating charge of the stacked storage capacitors. However, the resultant dynamic random access memory cells tend to fluctuate in data holding characteristics and transistor characteristics, and the prior art fabrication processes encounters a problem in low production yield.

### SUMMARY OF THE INVENTION

It is therefore an important object of the present invention to provide a semiconductor memory cell which is stable in the data holding characteristics and the transistor characteristics.

It is also an important object of the present invention to provide a process of fabricating a semiconductor memory cell which improves the production yield.

The present inventor contemplated the problems, and noticed that the access transistors 2a and 11 were covered with the silicon nitride layers 3b and 12c. When metal wirings (not shown) were completed, the semiconductor memory cells were treated with hydrogen atmosphere at 450 degrees in centigrade for 30 minutes. The hydrogen treatment was called as "hydrogen forming". The hydrogen forming deactivated crystal defects of the silicon, and decreased the contact resistance. Therefore, the hydrogen forming was indispensable for the stability of the characteristics of the memory cells. However, the hydrogen hardly penetrated through the silicon nitride layer. The present inventor concluded that the crystal defects allowed leakage current to flow out from the memory cells due to the insufficient hydrogen treatment.

To accomplish the object, the present invention proposes to form an inter-level insulating structure by using a material allowing hydrogen to penetrate therethrough faster than silicon nitride and providing a selectivity to materials for a storage electrode in an etching.

In accordance with one aspect of the present invention, there is provided a semiconductor memory cell comprising: an access transistor having a first impurity region and a second impurity region electrically connectable to each other; a storage capacitor having a first electrode provided over the access transistor, electrically connected to the first impurity region and formed of a first material, a dielectric film structure covering the first electrode and a second electrode opposed to the dielectric film structure to the first electrode; and an inter-level insulating structure inserted between the access transistor and the storage capacitor, and having a first insulating layer held in contact with the first electrode and formed of a second material, the second material allowing hydrogen to penetrate therethrough faster than through silicon nitride and having a selectivity with respect to the first material in an etching.

In accordance with another aspect of the present invention, there is provided a process of fabricating a semiconductor memory cell, comprising the steps of: a) fabricating an access transistor having a first impurity region and a second impurity region electrically connectable to each other; b) covering the access transistor with an inter-level insulating structure having a first insulating layer formed of first material and allowing hydrogen to penetrate therethrough faster than through a silicon nitride layer; c) providing a first portion of a storage electrode formed of a second material on the first insulating layer and held in contact with the first impurity region; d) covering the first portion and an exposed area of the first insulating layer with a first conductive layer formed of a third material and having a vertical portion held in contact with a vertical side surface of the first portion; e) covering the first conductive layer with a spacing layer of a fourth material; f) patterning the spacing layer into a cylindrical side wall spacer held in contact with the vertical portion of the first conductive layer by using a first etchant having a selectivity between the third material and the fourth material; g) covering the cylindrical side wall spacer and an exposed surface of the first conductive layer with a second conductive layer of a fifth material; h) patterning the second conductive layer into a second portion of the storage electrode held in contact with the cylindrical side wall spacer by using a second etchant having a selectivity between at least the first material, the third material, the fourth material and the fifth material; i) covering the first and second portions of the storage electrode with a dielectric film structure; j) covering the dielectric film structure with a plate electrode; and k) treating the resultant structure of the step k) with hydrogen for at least decreasing crystal defects.

### BRIEF DESCRIPTION OF THE DRAWINGS

The features and advantages of the semiconductor device and the process according to the present invention will be more clearly understood from the following description taken in conjunction with the accompanying drawings in which:
Figs. 1A to 1C are cross sectional views showing the prior art process sequence disclosed in Japanese Patent Publication of Unexamined Application No. 6-37271;
Figs. 2A to 2C are cross sectional views showing the prior art process sequence disclosed in Japanese Patent Publication of Unexamined Application No. 5-218333;
Figs. 3A to 3H are cross sectional views showing a process of fabricating a semiconductor memory device according to the present invention;
Figs. 4A to 4H are cross sectional views showing another process of fabricating a semiconductor memory device according to the present invention;
Fig. 5 is a cross sectional view showing a chemical mechanical polishing used in a first modification of the process shown in figures 3A to 3H;
Fig. 6 is a cross sectional view showing an etch-back used in a second modification of the process shown in figures 3A to 3H.

### DESCRIPTION OF THE PREFERRED EMBODIMENTS

### First Embodiment

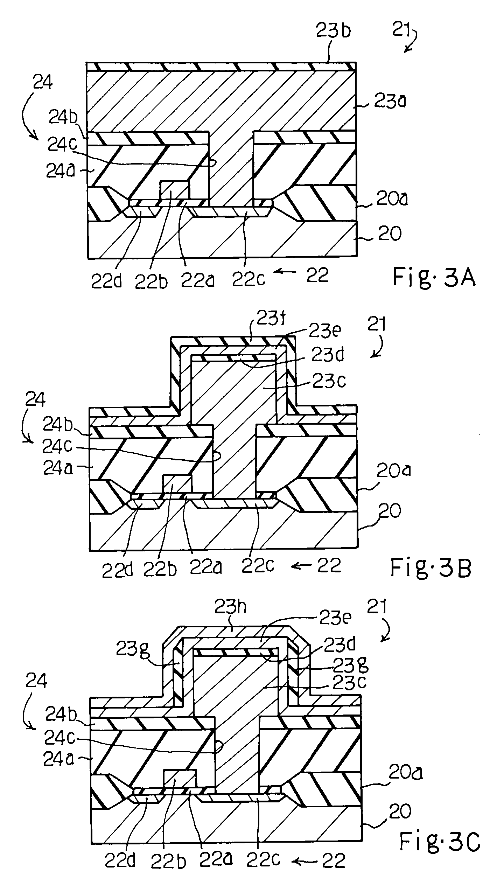

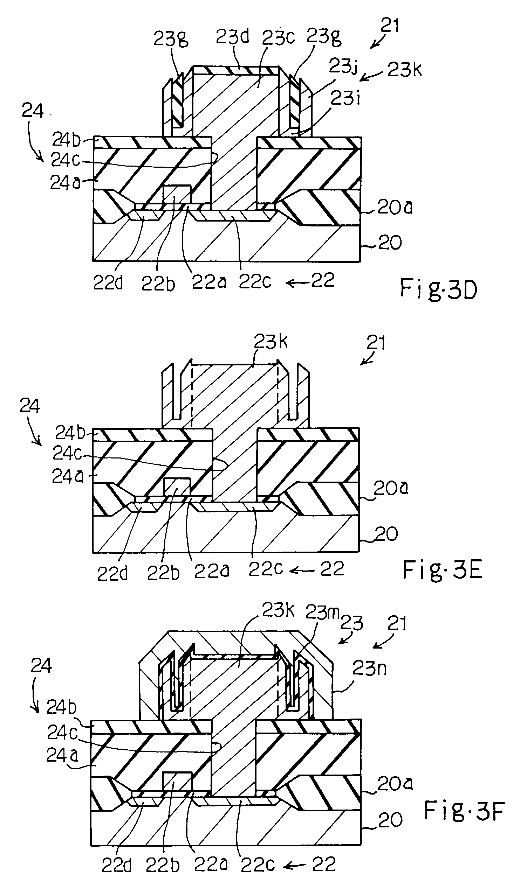

Figures 3A to 3H illustrate a process embodying the present invention. The process starts with preparation of a silicon substrate 20. A field oxide layer 20a is selectively grown to 450 nanometers thick on the major surface of the silicon substrate 20. The field oxide layer 20a defines a plurality of active areas, and one of the active areas is assigned to a stacked type dynamic random access memory cell 21 which is hereinbelow detailed. Although a plurality of dynamic random access memory cells are fabricated on the silicon substrate 20 together with other circuit components, description is focused on the dynamic random access memory cell 21 for the sake of simplicity.

An access transistor 22 and a stacked storage capacitor 23 form in combination the static type dynamic random access memory cell 21, and the access transistor 22 is fabricated on the active area as follows.

A thin gate oxide layer 22a is thermally grown on the active area, and polysilicon is deposited to 150 nanometers thick over the thick field oxide layer 20a and the thin gate oxide layer 22a. As a result, the thin gate oxide layer 22a is overlain by a polysilicon layer.

Photo-resist solution is spun onto the polysilicon layer, and is baked so as to form a photo-resist layer (not shown). A pattern image for a gate electrode is transferred from a photo-mask (not shown) to the photo-resist layer, and a latent image is formed in the photo-resist layer. The latent image is developed, and a photo-resist etching mask (not shown) is provided on the polysilicon layer. Using the photo-resist etching mask thus patterned through the lithographic process, the polysilicon layer is selectively etched away, and a gate electrode 22b is formed from the polysilicon layer.

Subsequently, arsenic is ion implanted into the active area in a self-aligned manner with the gate electrode 22b, and a source region 22c and a drain region 22d are formed in the active area. The source region 22c and the drain region 22d are opposite in conductivity type to the silicon substrate 20. The thin gate oxide layer 22a, the gate electrode 22b, the source region 22c and the drain region 22d as a whole constitute the access transistor 22. The source region 22c and the drain region 22d may have the LDD (Lightly Doped Drain) structure.

Subsequently, boro-phospho-silicate glass is deposited over the entire surface of the resultant structure by using a chemical vapor deposition, and the thick field oxide layer 20a and the access transistor 22 are covered with a boro-phospho-silicate glass layer. The boro-phospho-silicate glass layer is reflowed at 850 degrees in centigrade, and is, thereafter, subjected to an etch-back. The deposition, the reflowing and the etch-back are repeated, and a smooth surface is created on the boro-phospho-silicate glass layer 24a of 600 nanometers thick.

Silicon oxide is deposited to 200 nanometers thick over the boro-phospho-silicate glass layer 24a by using a chemical vapor deposition, and the boro-phospho-silicate glass layer 24a is overlain by a silicon oxide layer 24b. The boro-phospho-silicate glass layer 24a and the silicon oxide layer 24b form in combination an inter-level insulating structure 24.

A photo-resist etching mask (not shown) is provided on the silicon oxide layer 24b through the lithographic process, and exposes a part of the silicon oxide layer 24b and a part of the boro-phospho-silicate glass layer 24a to etchant. The etchant forms a contact hole 24c in the inter-level insulating structure 24, and the source region 22c is exposed to the contact hole 24c. The contact hole 24c is 500 nanometers in diameter.

Phosphorus-doped polysilicon is deposited over the entire surface of the resultant structure by using a chemical vapor deposition. The phosphorous-doped polysilicon fills the contact hole 24c, and swells out into a doped polysilicon layer 23a of 400 nanometers thick. Boro-phospho-silicate glass is deposited to 5 to 30 nanometers thick over the doped-polysilicon layer 23a, and the doped-polysilicon layer 23a is overlain by a boro-phospho-silicate glass layer 23b as shown in figure 3A.

A photo-resist etching mask (not shown ) is provided on the boro-phospho-silicate glass layer 23b through the lithographic process, and the boro-phospho-silicate glass layer 23b and the doped polysilicon layer 23a are selectively etched away so as to form a column portion 23c overlain by a boro-phospho-silicate glass strip 23d.

Subsequently, phosphorous-doped polysilicon is deposited to 50 nanometers thick over the entire surface of the resultant structure by using the chemical vapor deposition, and the resultant structure is topographically covered with a doped polysilicon layer 23e. Silicon nitride is deposited to 50 nanometers thick by using the chemical vapor deposition, and the doped polysilicon layer 23e is overlain by a silicon nitride layer 23f. The resultant structure is illustrated in figure 3B.

The silicon nitride layer 23f is exposed to an anisotropic etchant such as gaseous mixture of CF₄ and O₂. The anisotropic etchant forms a side wall 23g on the doped polysilicon layer 23e. Phosphorous-doped polysilicon is deposited to 50 nanometers thick over the entire surface of the resultant structure, and the doped polysilicon layer 23e and the side wall 23g are covered with a doped polysilicon layer 23h as shown in figure 3C.

Using the silicon oxide layer 24b and the boro-phospho-silicate glass strip 23d as an etching stopper, the doped polysilicon layers 23e and 23h are anisotropically etched away, and a connecting portion 23i and a cylindrical portion 23j are formed from the doped polysilicon layers 23e and 23h, respectively. The etchant has a large selectivity between the silicon oxide/boro-phospho-silicate glass and the polysilicon. The column portion 23c, the connecting portion 23i and the cylindrical portion 23j as a whole constitute a cylindrical storage electrode 23k, and the resultant structure is illustrated in figure 3D.

The side wall 23g of silicon nitride is etched away in phosphoric acid solution, and the boro-phospho-silicate glass strip 23d is removed by using a hydrofluoric acid. The resultant structure is illustrated in figure 3D.

The cylindrical storage electrode 23k is covered with a dielectric film structure 23m. In this instance, the dielectric film structure 23m is implemented by lamination of a silicon nitride film of 7 nanometers thick and a thermally oxidized silicon oxide film of 1-2 nanometers thick.

Subsequently, polysilicon is deposited to 200 nanometers thick by using the chemical vapor deposition, and the polysilicon layer is patterned into a plate electrode 23n as shown in figure 3F. The cylindrical storage electrode 23k, the dielectric film structure 23m and the plate electrode 23n as a whole constitute the stacked storage capacitor 23.

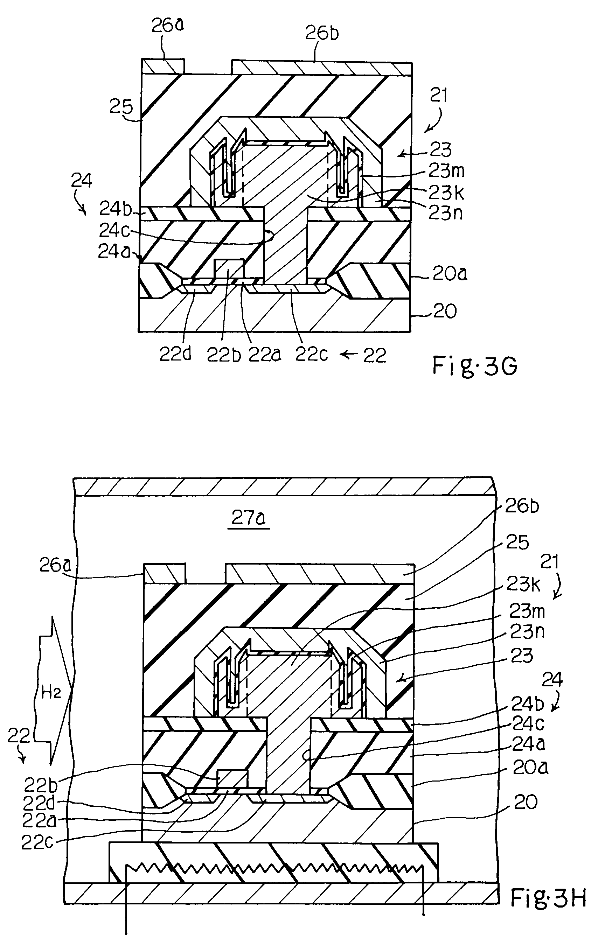

The resultant structure shown in figure 3F is covered with an inter-level insulating structure 25, and a contact hole (not shown) is formed in the inter-level insulating structures 25 and 24. The drain region 22d is exposed to the contact hole. Aluminum is deposited over the entire surface of the inter-level insulating structure 25, and the aluminum layer is patterned into aluminum wirings 26a and 26b. One of the aluminum wirings 25a and 26b passes through the contact hole, and is held in contact with the drain region 22d. The resultant structure is illustrated in figure 3G.

Subsequently, the resultant structure shown in figure 3G is placed in a chamber 27a, and hydrogen atmosphere is created in the chamber 27a. The hydrogen forming is carried out at 450 degrees in centigrade for 30 minutes as shown in figure 3H. The hydrogen is diffused through the inter-level insulating structures 25 and 24, and reaches the access transistor 22, because the silicon oxide and the boro-phospho-silicate glass allow hydrogen to penetrate therethrough faster than the silicon nitride layer. For this reason, the hydrogen forming cures the crystal defects, and lowers the contact resistance. Though now shown in the drawings, a passivation layer is formed over the wirings 26a and 26b.

The present inventor confirmed that the stacked storage capacitor were reliable in data holding characteristics.

As will be appreciated from the foregoing description, the silicon oxide layer 24b surely serves as the etching stopper during the patterning stage of the cylindrical portion 23j, and the silicon oxide layer 24b and the boro-phospho-silicate glass layer 24a allow the hydrogen to penetrate therethrough in the hydrogen forming stage. The semiconductor dynamic random access memory cell is reliable in data holding characteristics and transistor characteristics, and the process improves the production cost.

### Second Embodiment

Turning to figures 4A to 4H of the drawings, another process embodying the present invention also starts with preparation of a silicon substrate 40. A field oxide layer 40a is selectively grown on the major surface of the silicon substrate 40. The field oxide layer 40a defines a plurality of active areas, and one of the active areas is assigned to a stacked type dynamic random access memory cell 41 which is hereinbelow detailed.

An access transistor 42 and a stacked storage capacitor 43 form in combination the static type dynamic random access memory cell 41, and the access transistor 42 is fabricated on the active area as follows.

A thin gate oxide layer 42a is thermally grown on the active area, and polysilicon is deposited over the thick field oxide layer 40a and the thin gate oxide layer 42a. As a result, the thin gate oxide layer 42a is overlain by a polysilicon layer.

A photo-resist etching mask (not shown) is provided on the polysilicon layer. Using the photo-resist etching mask, the polysilicon layer is selectively etched away, and a gate electrode 42b is formed from the polysilicon layer.

Subsequently, arsenic is ion implanted into the active area in a self-aligned manner with the gate electrode 42b, and a source region 42c and a drain region 42d are formed in the active area. The source region 42c and the drain region 42d are opposite in conductivity type to the silicon substrate 40. The thin gate oxide layer 42a, the gate electrode 42b, the source region 42c and the drain region 42d as a whole constitute the access transistor 42.

Subsequently, the deposition of boro-phospho-silicate glass, the reflowing and the etch-back are repeated for forming a boro-phospho-silicate glass layer 44a, and a smooth surface is created on the boro-phospho-silicate glass layer 44a.

Silicon oxide is deposited over the boro-phospho-silicate glass layer 44a by using a chemical vapor deposition, and the boro-phospho-silicate glass layer 44a is overlain by a silicon oxide layer 44b. The boro-phospho-silicate glass layer 44a and the silicon oxide layer 44b form in combination an inter-level insulating structure 44, and the access transistor 42 and the inter-level insulating structure 44 are similar to the access transistor 22 and the inter-level insulating structure 24, respectively.

A photo-resist etching mask (not shown) is provided on the silicon oxide layer 44b through the lithographic process, and exposes a part of the silicon oxide layer 44b and a part of the boro-phospho-silicate glass layer 44a to etchant. The etchant forms a contact hole 44c in the inter-level insulating structure 44, and the source region 42c is exposed to the contact hole 44c.

Phosphorus-doped polysilicon is deposited over the entire surface of the resultant structure by using a chemical vapor deposition. The phosphorous-doped polysilicon fills the contact hole 44c, and swells out into a doped polysilicon layer of 400 nanometers thick. A photo-resist etching mask (not shown) is provided on the doped polysilicon layer, and the doped polysilicon layer is selectively etched away so as to form a block portion 43a as shown in figure 4A.

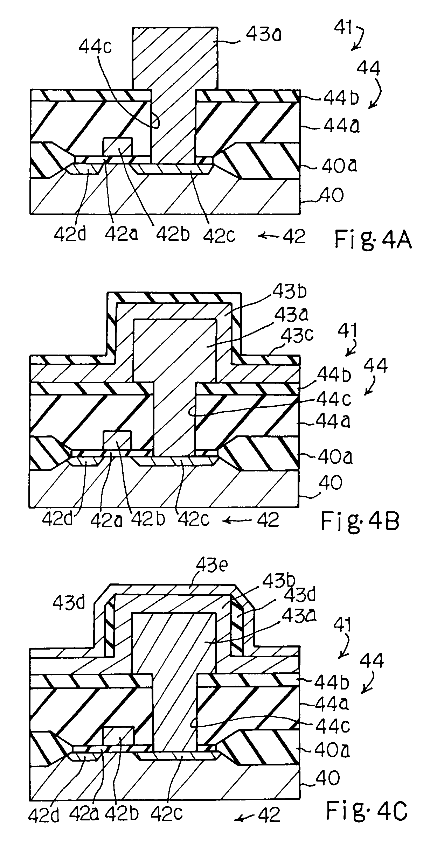

Phosphorous-doped polysilicon is deposited to 70 nanometers thick over the entire surface of the resultant structure by using the chemical vapor deposition, and a doped polysilicon layer 43b is topographically formed over the block portion 43a and the silicon oxide layer 44b. Silicon oxide is further deposited to 50 nanometers thick over the doped polysilicon layer 43b by using the chemical vapor deposition, and the doped polysilicon layer 43b is overlain by a silicon oxide layer 43c as shown in figure 4B. The silicon oxide layer 43c is replaceable with any material layer having a selectivity to the doped polysilicon layer 43b. For example, a silicon nitride layer is an example of the material layer.

Subsequently, the silicon oxide layer 43c is anisotropically etched away without an etching mask, and is formed into a side wall 43d. Phosphorous-doped polysilicon is deposited to 50 nanometers thick over the resultant structure by using the chemical vapor deposition, and the block portion 43a and the side wall 43d are covered with a doped polysilicon layer 43e as shown in figure 4C.

The doped polysilicon layers 43b and 43e are anisotropically etched without an etching mask until the side wall 43d is exposed. The doped polysilicon layer 43e is patterned into a cylindrical portion 43f as shown in figure 4D.

The side wall 43d is etched away by using hydrofluoric acid solution or hydrofluoric acid anhyddride gas. When the side wall 43d is removed, the doped polysilicon layer 43b serves as an etching stopper, and the etchant does not have an influence on the oxide layer 44b.

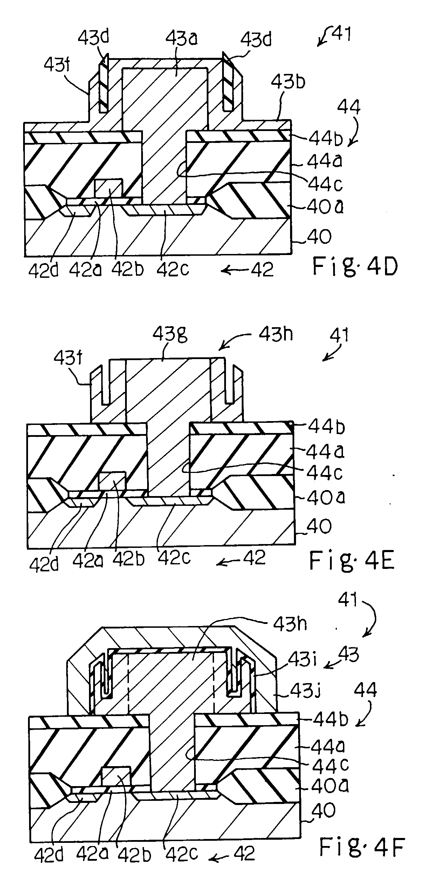

Subsequently, the doped-polysilicon layer 43b is anisotropically etched away until the oxide layer 43b is exposed. When the doped-polysilicon layer 43b is anisotropically etched away, the oxide layer 44b serves as an etching stopper. Thus, the doped-polysilicon layers 43d and 43e are partially formed into the cylindrical portion 43f, and partially formed into a column portion 43g together with the block portion 43a. The column portion 43g and the cylindrical portion 43f form in combination a cylindrical storage electrode 43h. The resultant structure is illustrated in figure 4E.

The cylindrical storage electrode 43h is covered with a dielectric film structure 43i which in turn is covered with a plate electrode 43j of polysilicon as shown in figure 4F.

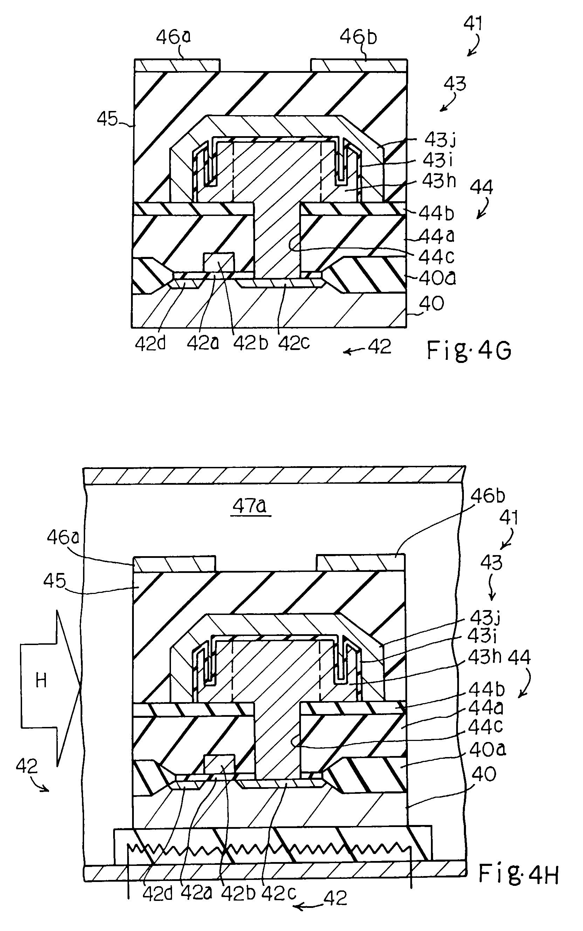

The resultant structure shown in figure 4G is covered with an inter-level insulating structure 45, and aluminum wirings 46a and 46b are patterned on the inter-level insulating structure 45 as shown in figure 4G. One of the aluminum wirings 46a/46b may pass through the inter-level insulating structures 44 and 45, and serve as a bit line.

The resultant structure shown in figure 4G is placed in a chamber 47a, and hydrogen-containing gas is introduced into the chamber 47a as shown in figure 4H. The hydrogen forming is carried out at 450 degrees in centigrade for 30 minutes. The hydrogen penetrates through the inter-level insulating structures 44 and 45, and reaches the access transistor 42. The hydrogen cures the crystal defects of silicon, and decreases the contact resistance. For this reason, leakage current is drastically decreased, and data holding characteristics are surely improved.

The aluminum wirings 46a/46b are covered with a passivation layer (not shown), and the semiconductor memory device is completed.

The dynamic random access memory cell is improved in data holding characteristics and transistor characteristics. The process shown in figures 4A to 4H improves the production yield of the semiconductor memory device as similar to the first embodiment. Moreover, the process shown in figures 4A to 4H is simpler than the process shown in figures 3A to 3H, because the process shown in figures 4A to 4h does not need the boro-phospho-silicate glass strip 23d. The side wall 43d is only expected to have a selectivity to the doped-polysilicon, and is not limited to the silicon oxide.

Although particular embodiments of the present invention have been shown and described, it will be obvious to those skilled in the art that various changes and modifications may be made without departing from the spirit and scope of the present invention.

For example, the dynamic random access memory cells may form a part of an ultra large scale integration together with other function blocks. Each active area may be assigned to a pair of memory cells.

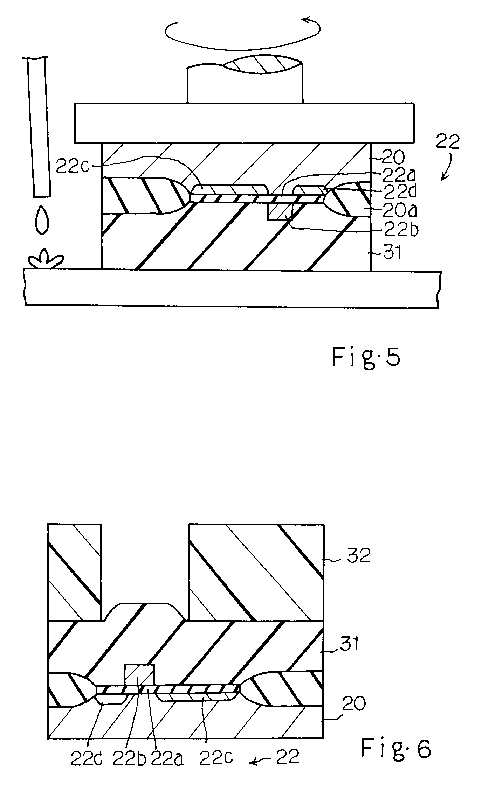

In the above described first embodiment, the inter-level insulating structure 24 is implemented by the combination of boro-phospho-silicate glass layer 24a and the silicon oxide layer 24b. However, the inter-level insulating structure 24 may be implemented by a thick silicon oxide layer 31 (see figures 5 and 6). The thick silicon oxide layer 31 is deposited by using a chemical vapor deposition, and is smoothened by using a chemical mechanical etching (see figure 5) or an etch-back to a portion exposed to a photo-resist etching mask 32 (see figure 6). Phospho-silicate glass layer may be used for the inter-level insulating structure 24/44 alone or together with a silicon oxide layer. The hydrogen penetrates through a phospho-silicate glass layer and/or a silicon oxide layer faster than through a silicon nitride layer.

The boro-phospho-silicate glass strip 23d may be replaced with a suitable material layer providing a large selectivity to the silicon oxide layer 24b. A phospho-silicate glass strip, a silicon nitride strip and an extremely thin silicon dioxide strip are examples of the suitable material layer. Although the silicon dioxide layer does not provide a large selectivity to the silicon oxide layer 24b, an extremely thin layer of the order of 5 nanometers to 30 nanometers thick does not have a band influence to the inter-level insulating structure 24. Moreover, the side wall spacer 23g may be formed of phospho-silicate glass or boro-phospho-silicate glass, because these material provide a large selectivity to the silicon oxide layer 24b.

The cylindrical storage electrodes 23k and 43h may be formed of amorphous silicon doped with dopant impurity. When the doped amorphous silicon is used for the cylindrical storage electrode 23k/43h, semi-spherical grains further increase the surface area of the cylindrical storage electrode 23k/43h.

The cylindrical storage electrodes 23k and 43h may be formed of refractory metal such as, for example, tungsten or molybdenum or ruthenium oxide.

Finally, the access transistor may be a thin film transistor formed over the major surface of a semiconductor substrate.

## Claims

1. A semiconductor memory cell comprising:
an access transistor (22; 42) having a first impurity region (22c; 42c) and a second impurity region (22d; 42d) electrically connectable to each other;
a storage capacitor (23; 43) having a first electrode (23k; 43g) provided over said access transistor, electrically connected to said first impurity region and formed of a first material, a dielectric film structure (23m; 43i) covering said first electrode and a second electrode (23n; 43j) opposed to said dielectric film structure to said first electrode; and
an inter-level insulating structure (24; 44) inserted between said access transistor and said storage capacitor, characterized in that
said inter-level insulating structure has a first insulating layer (24b; 44b) held in contact with said first electrode and formed of a second material, said second material allowing hydrogen to penetrate therethrough faster than through silicon nitride and having a selectivity with respect to said first material in an etching.

2. The semiconductor memory cell as set forth in claim 1, in which said first electrode includes a column portion (23c; 43g) electrically connected to said first impurity region and a cylindrical portion (23j; 43f) provided outside of said column port ion and connected to said column portion.

3. The semiconductor memory cell as set forth in claim 2, in which said column portion and said cylindrical portion are formed of polysilicon, and said first insulating layer is formed of a material selected from the group consisting of silicon oxide, phospho-silicate glass and boro-phospho-silicate glass.

4. The semiconductor memory cell as set forth in claim 2, in which said first electrode and said first insulating layer are formed of polysilicon and silicon oxide, and said inter-level insulating structure further has a second insulting layer (24a; 44a) formed of boro-phospho-silicate glass.

5. The semiconductor memory cell as set forth in claim 4, in which said second insulting layer (24a; 44a) has a flat top surface, and said first insulating layer (24b; 44b) is uniform in thickness.

6. A process of fabricating a semiconductor memory cell, comprising the steps of:
a) fabricating an access transistor (22; 42) having a first impurity region (22c; 4c) and a second impurity region (22d; 42d) electrically connectable to each other;
b) covering said access transistor with an inter-level insulating structure (24; 44) having a first insulating layer (24b; 44b) formed of first material and allowing hydrogen to penetrate therethrough faster than through a silicon nitride layer;
c) providing a first portion (23c; 43a) of a storage electrode (23k; 43h) formed of a second material on said first insulating layer and held in contact with said first impurity region;
d) covering said first portion and an exposed area of said first insulating layer with a first conductive layer (23e; 43b) formed of a third material and having a vertical portion held in contact with a vertical side surface of said first portion;
e) covering said first conductive layer with a spacing layer (23f; 43c) of a fourth material;
f) patterning said spacing layer into a cylindrical side wall spacer (23g; 43d) held in contact with said vertical portion of said first conductive layer by using a first etchant having a selectivity between said third material and said fourth material;
g) covering said cylindrical side wall spacer and an exposed surface of said first conductive layer with a second conductive layer (23h; 43e) of a fifth material;
h) patterning said second conductive layer into a second portion (23j; 43f) of said storage electrode held in contact with said cylindrical side wall spacer by using a second etchant having a selectivity between at least said first material, said third material, said fourth material and said fifth material;
i) covering said first and second portions of said storage electrode with a dielectric film structure (23m; 43i);
j) covering said dielectric film structure with a plate electrode (23h; 23n); and
k) treating the resultant structure of said step k) with hydrogen for at least decreasing crystal defects.

7. The process as set forth in claim 6, in which said step b) includes the sub-steps of
b-1) depositing a sixth material over said access transistor for forming a second insulating layer (23a; 44a),
b-2) smoothening a top surface of said second insulating layer, and
b-3) uniformly depositing said first material on said top surface of said second insulating layer for forming said first insulating layer (24b; 44b).

8. The process as set forth in claim 7, in which said sixth material is boro-phospho-silicate glass, and said sub-step b-2) is carried out by using a reflow and an etch-back.

9. The process as set forth in claim 6, in which said step b) includes the sub-steps of
b-1) depositing said first material over said access transistor for forming said first insulating layer, and
b-2) smoothening a top surface of said first insulating layer.

10. The process as set forth in claim 9, in which said sub-step b-2) is carried out by using a chemical mechanical polishing.

11. The process as set forth in claim 7, in which said sub-step b-2) is carried out by using an etch-back to a sub-surface of said top surface uncovered with an etching mask (32).

12. The process as set forth in claim 6, in which the step c) includes the sub-steps of
c-1) depositing said second material over said first insulating layer for forming a third conductive layer (23a),
c-2) depositing a sixth material over said third conductive layer for forming a second insulating layer (23b),
c-3) providing a first photo-resist etching mask on said second insulating layer, and
c-4) successively etching said second insulating layer and said third conductive layer uncovered with said first photo-resist etching mask for forming said first portion (23c) covered with a strip (23d) of said sixth material.

13. The process as set forth in claim 12, in which said step h) includes the sub-steps of
h-1) anisotropically etching said first conductive layer (23e) and said second conductive layer (23h) by using a first sub-etchant of said second etchant having a selectivity between said first, fourth and sixth materials and said third and fifth materials until said cylindrical side wall spacer (23g) and said strip (23d) are exposed for forming said second portion,
h-2) etching said cylindrical side wall spacer (23g) by using a second sub-etchant of said second etchant having a selectivity between said first, third, fifth and sixth materials and said fourth material, and
h-3) etching said strip (23d) by using a third sub-etchant of said second etchant having a selectivity between said first, second, third and fifth materials and said sixth material.

14. The process as set forth in claim 13, in which said first material, said second material, said third material, said fourth material, said fifth material and said sixth material are silicon oxide, polysilicon, polysilicon, silicon nitride, polysilicon and boro-phospho-silicate glass, respectively.

15. The process as set forth in claim 6, in which said step h) includes the sub-steps of
h-1) anisotropically etching said second conductive layer (43e) and said first conductive layer (43b) by using a first sub-etchant of said second etchant having a selectivity between said fourth material and said third and fifth materials until said cylindrical side wall spacer is exposed for forming a cylindrical portion from said second conductive layer,
h-2) etching said cylindrical side wall spacer (43d) by using a second sub-etchant of said second etchant having a selectivity between said third material and said fourth material, and
h-3) uniformly etching said first conductive layer (43b) and said cylindrical portion by using a third sub-etchant of said second etchant having a selectivity between said first material and said third and fifth materials until said first portion is exposed.

16. The process as set forth in claim 15, in which said first material, said second material, said third material, said fourth material and said fifth material are silicon oxide, polysilicon, polysilicon, silicon oxide and polysilicon, respectively.
